Europäisches Patentamt

European Patent Office

Office européen des brevets

(11) Publication number: **0 217 137 B1**

(12) **EUROPEAN PATENT SPECIFICATION**

(45) Date of publication of patent specification: **08.04.92**   (51) Int. Cl.⁵: **G03F 7/038**

(21) Application number: **86111870.1**

(22) Date of filing: **27.08.86**

(54) **Photopolymerizable composition of acrylic copolymer containing dicyclopentenyl acrylate or methacrylate.**

(30) Priority: **29.08.85 US 770517**

(43) Date of publication of application:
**08.04.87 Bulletin 87/15**

(45) Publication of the grant of the patent:
**08.04.92 Bulletin 92/15**

(84) Designated Contracting States:
**BE DE FR GB**

(56) References cited:
**EP-A- 0 043 116      EP-A- 0 142 463**
**EP-A- 0 162 570      EP-A- 0 164 270**
**DE-A- 2 816 774      GB-A- 2 130 227**

**CHEMICAL ABSTRACTS, vol. 99, no. 6, 8th August 1983, page 491, no. 46024h, Columbus, Ohio, US; & JP-A-58 10 737 (SEKISUI CHEMICAL CO., LTD.) 21-01-1983**

**CHEMICAL ABSTRACTS, vol. 99, no. 6, 8th August 1983, page 491, no. 46027m, Columbus, Ohio, US; & JP-A-58 54 337 (SEKISUI CHEMICAL CO., LTD.) 31-03-1983 (Cat. D)**

(73) Proprietor: **E.I. DU PONT DE NEMOURS AND COMPANY**
**1007 Market Street**
**Wilmington Delaware 19898(US)**

(72) Inventor: **Held, Robert Paul**
**82 Knox Lane**
**Englishtown New Jersey 07726(US)**

(74) Representative: **Werner, Hans-Karsten, Dr. et al**
**Deichmannhaus am Hauptbahnhof**
**W-5000 Köln 1(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

This invention relates to photopolymerizable or photocrosslinkable compositions. More particularly this invention relates to photopolymerizable or photocrosslinkable compositions of an acrylic copolymer containing dicyclopentenyl acrylate or methacrylate, a photoinitiator, and optionally an ethylenically unsaturated compound.

A wide range of acrylic, urethane, cinnamic, and pentenyl photopolymerizable and photocrosslinkable compositions are known. One particular composition described in Japanese Patent Application No. 56-154404, Publication No. 58/54,337 is useful in the preparation of photoresists. A particular photosensitive copolymer disclosed is an acrylic copolymer containing 10% by weight of dicyclopentenyl groups as illustrated in Reference Example 1. The copolymer is used in conjunction with an acrylic ethylenically unsaturated compound and photoinitiator to prepare a photopolymerizable element developable in sodium carbonate aqueous solution. An advantage of the particular copolymer according to the Japanese publication is that the photohardening reaction is not inhibited even when it is exposed to actinic radiation in air.

While it is known, in general, that dicyclopentenyl groups can be present in copolymers that photocrosslink in a photopolymerizable system, there is no teaching relating to the development latitude and quality of the image of such systems.

Surprisingly, when 15 to 25% dicyclopentenyl acrylate or methacrylate is present in an acrylic polymer together with a photoinitiator or photoinitiator system excellent development latitude and image quality are achieved.

EP-A-0 162 570 relates to flexographic printing plate wherein a dicyclopentenyl arcylate copolymer is utilized, the copolymer is prepared from at least three monomer units, i.e., (A) conjugated diene, (B) $\alpha$-,$\beta$-ethylenerally unsaturated carboxylic acid, (C) polyfunctional alkenyl compound having non-conjugated carbon - carbon double bonds, (D) and (E) components being optional.

EP-A-0 164 270 is related to a light-sensitive composition which contains a copolymerized resin (A) which can contain dicyclopentenyl acrylate and vinyl compound having a secondary or tertiary nitrogen atom (B) as well as a third component which is an ethylenically unsaturated monomeric compound (component C).

In accordance with this invention there is provided a photopolymerizable or photocrosslinkable composition containing an acrylic copolymer with dicyclopentenyl groups consisting only of acrylic monomers, the acrylic copolymer containing 15 to 25% by weight dicyclopentenyl acrylate or methacrylate, and a photoinitiator or photoinitiator system.

This invention is based on the discovery that the weight percentage of 15 to 25 dicyclopentenyl substituent in an acrylic copolymer is critical for proper image quality in a photopolymerizable or photocrosslinkable composition. When 5 to 10% by weight dicyclopentenyl is present satisfactory images are not obtained. Dicyclopentenyl present in an acrylic copolymer in amounts above 25 weight percent, e.g., 30 to 40 weight percent, results in an insoluble composition which is not satisfactory for use in a photopolymerizable element wherein a layer of the composition is present on a suitable support.

The composition described by EP-A-0 162 570 is a different copolymer than the polymeric compound obtained according to the invention namely by reacting at least one acrylic or methacrylic monomer and dicyclopentenyl acrylate or metacrylate monomer as defined above.

The document EP-A-0 164 270 teaches that only the addition of a diene namely butadiene will give a water developable photopolymerizable composition for the production of printing plates which water developable and also water restistent following developing.

While the photopolymerizable or crosslinkable composition consists essentially of an acrylic copolymer and photoinitiator or photoinitiator system as described broadly above, other additional components can be present in the composition which do not prevent the advantages of the invention from being realized. At least one ethylenically unsaturated compound, e.g., acrylic ester type, as more specifically described below, is preferably present in the composition, as well as known thermal inhibitors, plasticizers, dyes, pigments, optical brightening agents, adhesive aids, antihalation compounds, etc.

The acrylic copolymer component of the photopolymerizable or photocrosslinkable composition serves as a binder component and an ethylenically unsaturated component. The acrylic copolymers can be prepared by solution polymerization or other known procedures. In addition to the 10 to 25% by weight of dicyclopentenyl acrylate (DCPA) or methacrylate (DCPMA), other monomers that can be used to prepare the acrylic copolymer include: methyl methacrylate (MMA), acrylic acid (AA), dimethylaminoethyl acrylate (DMAEA), methacrylate (DMAEMA), methacrylic acid (MAA), hydroxyethylmethacrylate (HEMA), alkyl acrylates or methacrylates, e.g., ethyl methacrylate (EMA), butyl acrylate (BA), etc. The acrylic copolymers can be either acid-containing copolymers, e.g., DCPMA/AA/MMA, DCPMA/AA, etc., alkaline-containing copolymers, e.g., DCPMA/DMAEMA/HEMA/MMA, etc.; amphoteric-containing copolymers DCPMA with amine and acid substituents, etc.; or neutral copolymers, e.g., DCPMA/MMA, etc. The acrylic copolymers are soluble in different solvents, e.g., acid or basic types, organic solvents, etc. depending on the functionality of the copolymer, e.g., acid, basic, amphoteric or neutral. In a process for preparing the aforementioned acrylic copolymers, a monomeric mixture is prepared which contains at least one acrylic or methacrylic monomer and 15 to 25% by weight dicyclopentenyl acrylate or methacrylate monomer. The mixture is then added to a suitable solvent in a nitrogen purged reaction vessel and the solvent mixture refluxed for longer than one hour. The acrylic copolymer is recovered from the solvent. For example, when the acrylic copolymer is solvent soluble recovery can be made by precipitation with water; when the acrylic copolymer is caustic soluble recovery can be made by dispersion with ammonia and precipitation with acid; when the acrylic copolymer is acid soluble recovery can be made by dissolving in acid and precipitating with ammonia. Preferred acrylic copolymers are described below. Other preferred acrylic copolymers contain DCPMA (25%)/MMA (55%)/MAA (20%); DCPM (25%)/MMA (12%)/HEMA (28%)/DMAEMA (35%); DCPM (25%)/AA (15%)/MMA (60%); and DCPM (25%)/MMA (75%).

The acrylic copolymer can be used to make a photopolymerizable or crosslinkable composition by combining with a photoinitiator or photoinitiator system. The latter is present in an amount of 0.01 to 10% by weight based on the total weight of the composition. Suitable photoinitiators or photoinitiator systems include: the substituted or unsubstituted polynuclear quinones which are compounds having two intracyclic carbon atoms in a conjugated carbocyclic ring system, e.g., 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2-3-diphenylanthraquinone, sodium salt of anthraquinone alpha-sulfonic acid, 3-chloro-2-methyl-anthraquinone, retenequinone, 7,8,9,10-tetrahydronaphthacenequinone, and 1,2,3,4-tetrahydrobenz(a)-anthracene-7,12-dione Other photoinitiators which are also useful, even though some may be thermally active at temperatures as low as 85°C, are described in U.S. Patent No. 2,760,863 and include vicinal ketaldonyl alcohols, such as benzoin, pivaloin, acyloin ethers, e.g., benzoin methyl and ethyl ethers; alpha-hydrocarbon-substituted aromatic acyloins, including alpha-methylbenzoin, alpha-allylbenzoin and alpha-phenylbenzoin. Photoreducible dyes and reducing agents disclosed in U.S. Patents: 2,850,445; 2,875,047: 3,097,096; 3,074,974; 3,097,097; and 3,145,104 as well as dyes of the phenazine, oxazine, and quinone classes; Michler's ketone, benzophenone, 2,4,5-triphenyl-imidazolyl dimers with hydrogen donors, and mixtures thereof as described in U.S. Patents: 3,427,161; 3,479,185; and 3,549,367. Also useful with photoinitiators and photoinhibitors are sensitizers disclosed in Dueber U.S. Patent No. 4,162,162. Following the procedure of Example 1 of the last stated patent, positive images can be made. The disclosures in the stated patents are incorporated herein by reference.

Optionally, but preferably, at least one ethylenically unsaturated monomeric compound, can be present in the photopolymerizable or photocrosslinkable composition. While not being limited to the following theory, the ethylenically unsaturated monomer molecules, which are smaller than those of the acrylic copolymer, are believed to be able to interdisperse throughout the composition and thus provide more effective photopolymerization or photocrosslinking. It is believed that the optional monomer provides a higher density of unsaturation in the composition.

Suitable monomers useful in the photopolymerizable compositions include those described in U.S. Patent Nos. 2,760,863; 2,791,504; 2,927,022; 3,261,686 and 3,380,831, the disclosures of which are incorporated herein by reference. Monomers which can be used as the sole monomer or in combination with others include: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent No. 3,380,831, 2,2-di(p-hydroxyphenyl)-propane diacrylate, pentaerythritol tetraacrylate, 2,2-di-(p-hydroxyphenyl)-propane dimethacrylate, triethylene glycol diacrylate, polyoxyethyl-2,2-di-(p-hydroxyphenyl)-propane dimethacrylate, di-(3-methacryloxy-2-hydroxypropyl) ether of bisphenol-A, di-(2-methacryloxyethyl) ether of bisphenol-A, di-(3-acryloxy-2-hydroxypropyl) ether of bisphenol-A, di-(2-acryloxy-ethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, trimethylol propane ethoxylate triacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene. Photopolymerizable or photocrosslinkable compositions contain the acrylic copolymer in an amount of 30 to 95% by weight, photoinitiator or photoinitiator system in an amount of 0.1 to 10% by weight and monomeric compound in an amount of 0 to 65% by weight. Preferred ranges for the respective components are: 40 to 60%; 1 to 6%; and 20 to 50%, all percentages being based on the total weight of the dry composition.

Thermal polymerization inhibitors that can be used in photopolymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, pyridine, nitrobenzene and dinitrobenzene, p-toluquinone and chloranil. Also useful for thermal polymerization inhibition are the nitroso compositions disclosed in U.S. Patent No. 4,168,982. The thermal inhibitor can be present in amount of 0.001 to 1.0% by weight based on the total weight of the composition.

The other additional additives described above can be present in amounts known to those skilled in the art. The presence of a plasticizer is useful as noted in Example 1 below.

The photopolymerizable or photocrosslinkable compositions can be coated or adhered to a support by techniques known to those skilled in the art. Suitable supports include: films composed of high polymers which are cast as films from molten polymer, such as polyamides, e.g., polyhexamethylene sebacamide, polyhexamethylene adipamide, polyolefins, e.g., polypropylene, polyesters, e.g., polyethylene terephthalate, polyethylene terephthalate/isophthalate; vinyl polymers, e.g., vinyl acetals, vinylidene chloride/vinyl chloride copolymers, polystyrene, polyacrylonitrile; and cellulosics, e.g., cellulose acetate, cellulose acetate/butyrate, cellophane. A particularly preferred support material is polyethylene terephthalate film of the kind described in Alles et al., U.S. Pat. No. 2,627,088 and Alles, U.S. Pat. No. 2,779,684, with or without the surface coating described in the former patent. The support may have a resin "sub" or other layer thereon which may or may not be soluble and which for purposes of this invention is considered part of the support. However, the total thickness of the photopolymerizable layers and any soluble sub or underlayer should not exceed 0.003 inch (0.075 mm). By "soluble" is meant solubility in a solvent in which the photopolymerizable layer is developable. Preferred soluble sub layers have a thickness not exceeding about 0.0002 inch (0.005 mm). Where the particular application does not require that the base support be transparent, the photopolymerizable layers may usefully be present on an opaque support, such as paper, especially waterproof photographic paper; thin metal sheets, especially aluminum and copper sheets, cardboard, etc. The dry thickness of the photopolymerizable or photocrosslinkable layer on the support is 0.0001 to 0.01 inch (0.0025 to 0.25 mm).

Optionally, but preferably, an overcoat layer is present on the photopolymerizable or photocrosslinkable layer. The preferred overcoat is an aqueous soluble layer, e.g., soluble in a caustic solution or in water alone. In general, the overcoat layer is soluble in a solvent for the photopolymerizable or photocrosslinkable composition. Suitable overcoat layers are described in Alles U.S. Patent No. 3,458,311. e.g., polyvinyl alcohol and its partial esters, ethers and acetals that contain a substantial amount of unsubstituted vinyl alcohol units so that they have the requisite solubility in water. Water soluble polyvinyl alcohol is preferred. Suitable polymers include 88% to 99% hydrolyzed polyvinyl acetate. Other useful polymers include polyvinyl pyrrolidones, methyl vinyl ether/maleic anhydride copolymers, and mixtures of these polymers.

The photopolymerizable or photocrosslinkable element as described above is imagewise exposed, e.g., for about 2 seconds to about 5 minutes, through a suitable phototool, mask or transparency, e.g., a halftone dot image, to a source of actinic radiation which polymerizes the photopolymerizable or photocrosslinkable layer in the areas beneath the clear image areas. The actinic radiation sources must transmit radiation in the actinic region that the free radical producing initiator is sensitive. Suitable sources include those rich in ultraviolet radiation, e.g., those disclosed in Plambeck, U.S. Patent No. 2,760,863, Chu and Cohen, U.S. Patent No. 3,649,268, Peiffer U.S. Patent No. 4,157,407 and Haney and Lott, U.S. Patent No. 4,411,980, the disclosures of which are incorporated herein by reference.

The imagewise exposed photopolymerized or photocrosslinked element is developed by treating the element (after removal of the overcoat layer, if present, with water or other solvent) with a caustic solution or other suitable solvent normally for 0.125 to 5.0 minutes to remove all the unexposed areas down to the support. The element can be placed in the developer solution and agitation applied or the caustic solution can be applied by spraying, brushing or rubbing onto the surface. Suitable preferred caustic solutions include: hydroxides, carbonates, acetates and ammonia. The developer solution can be heated, e.g., up to 40°C, but this is not necessary. A water rinse generally follows the imagewise development. A preferred embodiment of the invention is described in Example 1.

The photopolymerizable or photocrosslinkable compositions are useful in the preparation of high speed photopolymerizable or photocrosslinkable elements, e.g., a layer of the composition on a support. The elements are useful in electronic circuit fabrication preferably wherein the support is removable and for standard reproduction and printing uses, e.g., as a photopolymer or photocrosslinkable litho film. The compositions are useful in both positive and negative working modes.

## Examples

The invention is illustrated by the following examples which illustrate but does not limit the invention. The percentages set forth therein are by weight and the abbreviations used are the same as set forth above.

## Preparation 1

DCPM (25%/MMA (12%)/HEMA (28%)/DMAEMA (35%)

A solution polymerization apparatus was charged with 0.12 g 2,2'-azobis(2-methylbutanenitrile) initiator, 90 g toluene and 90 g ethyl acetate. The system was flushed with nitrogen and heated with steam while maintaining stirring and water condensation for reflux. When the solvent started boiling the following blend of monomer was added over a 2 hour period.

| Ingredient | Amount (g) |
|---|---|
| Dicyclopentenyl methacrylate (DCPM) | 46.0 |
| Methyl methacrylate (MMA) | 22.0 |
| Hydroxyethyl methacrylate (HEMA) | 51.0 |
| Dimethylaminoethyl methacrylate (DMAEMA) | 64.0 |
| 2,2'-azobis(2-methylbutanenitrile) | 1.8 |
| Toluene | 90.0 |
| Ethyl acetate | 90.0 |

The reaction was heated for one more hour and then cooled. The solvent was evaporated and the resulting polymer pulverized to give a yield of 153 g.

The solvent polymerization was repeated except that after cooling the copolymer was dissolved in hydrochloric acid and then precipitated with ammonia and filtered, dried and ground to give a yield of 163 g.

## Preparation 2

A series of copolymers having varying DCPM content were prepared following the procedure of Preparation 1 by varying the monomer addition and in the case of the highest DCPM content copolymer the elimination of methyl methacrylate.

The acrylic copolymer components expressed in percent were as set forth in Table I.

Table I

Acrylic

| Copolymer | DCPM | MMA | HEMA | DMAEMA |
|---|---|---|---|---|
| 1 | 5 | 32 | 28 | 35 |
| 2 | 10 | 27 | 28 | 35 |
| 3 | 15 | 22 | 28 | 35 |
| 4 | 20 | 17 | 28 | 35 |
| 5 | 25 | 12 | 28 | 35 |
| 6 | 30* | 7 | 28 | 35 |
| 7 | 40* | – | 26.5 | 33.5 |
| 8 (Control) | 0 | 37 | 28 | 35 |

\* would not dissolve in organic solvents used to prepare the photopolymerizable or photocross- linkable compositions

Copolymer 8 served as a control since it had all components except for the dicyclopentenyl component.

Preparation 3

Caustic soluble copolymer DCPM (25%)/AA (15%)/MMA (60%).

Using the procedure described in preparation 1, the following monomer mixture was added to the charged reactor over a three hour period.

| Ingredient | Amount (g) |
|---|---|
| Methyl methacrylate | 110.0 |
| Acrylic acid | 27.5 |
| Dicyclopentenyl methacrylate | 45.5 |
| 2,2'-azobis(isobutyronitrile) | 1.8 |
| Toluene | 90.0 |
| Ethyl acrylate | 90.0 |

After the polymerization proceeded for one more hour it was cooled and aqueous ammonia was added with stirring to disperse the copolymer. The pH was measured as 9.4. Then , HCl was added to precipitate the copolymer at a pH of 1.0. It was filtered and washed with water, then dried at 75°C and pulverized.

Preparation 4

Solvent soluble copolymer DCPM (25%)/MMA (75%)

The copolymer was prepared as in preparation 1 starting with 46.0 g DCPM and 137.0 g MMA for the monomer mixture. After cooling 2000 g water was added to precipitate to copolymer. It was filtered, dried and pulverized to give a yield of 142.0 g.

Example 1

Photopolymer or Photocrosslinkable solutions were prepared as follows:

| Ingredient | Amount (g) | Amount (g) |
|---|---|---|
| Methylene chloride | 92.0 | 92.0 |
| Methanol | 8.0 | 8.0 |
| Acrylic copolymer | 10.0 | 10.0 |
| Plasticizer SC (triethylene glycol dicaprate and triethylene glycoldicaprylate, Drew Chemical Co.) | 2.5 | - |
| Benzophenone | 2.1 | 2.1 |
| Michler's ketone | 0.3 | 0.3 |
| 2,2'-bis(o-chlorophenyl)-4,4',5,5'-tetraphenylbiimidazole | 1.0 | 1.0 |
| 2-mercaptobenzoxazole | 0.4 | 1.0 |
| Alcoblak® 300A (colloidal furnace black 35% by weight in isopropanol, Borden Chemical) | 10.0 | 10.0 |
| Triethylene glycol dimethacrylate | - | 5.0 |
| Trimethylol propane triacrylate | - | 5.0 |

Except for the acrylic copolymers 6 and 7, Preparation 2 30% and 40% copolymers which were insoluble, acrylic copolymers 1 to 5 from Preparation 2 were used to prepare the solutions. The solutions were each coated onto a polyethylene terephthalate support with a 0.002 inch (0.05 mm) doctor knife and dried to provide 10 photopolymer elements, both with and without added monomer.

An oxygen barrier layer was provided by lamination of a polyvinyl alcohol coating on polyethylene terephthalate film 0.001 inch (0.025 mm) in thickness.

Samples of these photopolymer elements after peeling off the polyethylene terephthalate film, were imagewise exposed through a target with a pulsed Xenon arc at 4 Kw for 30, 60 and 90 seconds at a distance of 46 cm. The exposed elements were processed first in water to remove the polyvinyl alcohol layer and then in 15% acetic acid to solubilize the unexposed areas followed by 41°C water to remove the solubilized areas using 20 kg/cm$^2$ pressure in a machine in which the speed was varied from 100 to 225 cm/minute throughput.

Upon examination of the processed elements, it was observed that 15, 20 and 25% dicyclopentenyl substituent inclusion in the copolymer used in the composition either with or without additional monomer gave superior image quality than 5 and 10% dicyclopentenyl substituent inclusion where only marginal imaging response was observed. The addition of monomer increased photospeed and development latitude.

Comparative Example

The control copolymer (8) of Preparation 2 was used to prepare a monomer containing photopolymer element as described in Example 1. When tested under identical conditions with the element containing 25% DCPM, the control copolymer with equivalent processing time gave poorer image quality, e.g., inability to hold small highlight dots, and poorer development latitude.

Example 2

A photopolymer solution was prepared containing:

| Aqueous Phase Ingredient | Amount (g) |
|---|---|
| Preparation 3 copolymer | 10.0 |
| Conc. NH$_3$ | 2.0 ml |
| Water | 100.0 ml |
| Triton®QS44 phosphate ester surfactant Rohm & Haas, Phila., PA | 1.0 |

| Organic Phase Ingredient | Amount (g) |
|---|---|
| Benzophenone | 0.7 |
| Michler's ketone | 0.1 |
| Trimethylol propane triacrylate | 3.0 |
| Methylene chloride | 15.0 |

The phases were placed in a blender and emulsified along with 2.0 ml of a 5% solution of FC 128 fluorinated alkyl polyoxethylene ethanol (Minnesota Mining and Manufacturing Company, St. Paul, Minnesota).

The emulsion was coated and dried as described in Example 1 to give a homogenous film from which samples was exposed for 30, 60 and 90 seconds and then developed for 1 minute with a 15% sodium carbonate solution followed by a water rinse.

High quality images were obtained as in Example 1. The films showed high photospeed and wide development latitude. Evaluation of the film revealed that they could be useful for either reproduction or printing applications.

Example 3

A photopolymer solution was prepared containing:

| Ingredient | Amount (g) |
|---|---|
| Preparation 4 copolymer | 10.0 |
| Trimethylolpropane triacrylate | 3.5 |
| Benzophenone | 0.8 |
| 2,2'-bis(o-chlorophenyl)-4,4',5,5'-tetraphenylbiimidazole | 0.1 |
| Michler's ketone | 0.02 |
| Leuco crystal violet | 0.05 |
| Methylene chloride | 130.0 |

The solution was coated on a polyethylene terephthalate support with a 0.010 inch (0.254 mm) doctor knife to yield a 0.25 mm thick film resist which was laminated to a copper circuit board and given the same exposure and processing used for Du Pont Riston® photopolymer resist sold commercially. Samples were etched with $FeCl_3$ and then stripped in commercial stripper to show that the film could perform all the functions of commercially available solvent developable photoresist films. The same advantage for photospeed and development latitude was observed with this solvent developable film as was observed with the elements described in the preceding examples.

**Claims**

1. A photopolymerizable or Photocrosslinkable composition containing an acrylic copolymer consisting of acrylic monomers only and a photoinitiator or photoinitiator system, characterized in that the acrylic copolymer contains 15 to 25% by weight dicyclopentenyl acrylate or methacrylate.

2. A photopolymerizable or photocrosslinkable composition according to claim 1 wherein the acrylic copolymer contains methyl methacrylate.

3. A photopolymerizable or photocrosslinkable composition according to claim 1 or 2 wherein the acrylic copolymer also contains acrylic acid.

4. A photopolymerizable or photocrosslinkable composition according to any of claims 1 - 3 wherein the acrylic copolymer also contains dimethylaminoethyl methacrylate.

5. A photopolymerizable or photocrosslinkable composition according to any of claims 1 to 4 wherein at least one ethylenically unsaturated monomeric compound is present.

6. A photopolymerizable or photocrosslinkable composition according to claim 5 wherein the acrylic copolymer contains methyl methacrylate.

7. A photopolymerizable or photocrosslinkable composition according to claim 6 wherein the acrylic copolymer also contains acrylic acid.

8. A photopolymerizable or photocrosslinkable composition according to claims 6 or 7 wherein the acrylic copolymer also contains dimethylaminoethyl methacrylate.

9. A composition according to any of the proceeding claims coated on a support.

10. A composition according to claim 9 overcoated with polyvinyl alcohol.

11. A process for producing a photopolymerizable or photocrosslinkable composition according to claim 1 consisting essentially of the steps:
(a) preparing a monomeric mixture containing at least one acrylic or methacrylic monomer and 15 to 25% by weight dicyclopentenyl acrylate or methacrylate monomer,
(b) adding the monomeric mixture to solvent in a nitrogen purged reaction vessel and refluxing for longer than one hour,
(c) recovering the acrylic copolymer from the solvent and
(d) adding a photoinitiator or photoinitiator system.

12. A process according to claim 11 wherein the acrylic copolymer is solvent soluble and the recovery occurs by precipitation with water.

13. A process according to claim 11 wherein the acrylic copolymer is caustic soluble and the recovery occurs by dispersion with ammonia and precipitation with acid.

14. A process according to claim 11 wherein the acrylic copolymer is acid soluble and the recovery occurs by dissolving in acid and precipitating with ammonia.

**Revendications**

1. Une composition photopolymérisable ou photoréticulable contenant un copolymère acrylique consistant en monomères acryliques, et seulement un photoamorceur ou un système photoamorceur, caractérisée en ce que le copolymère acrylique contient de 15 à 25% en poids d'acrylate ou de méthacrylate de dicyclopenténhyle.

2. Une composition photopolymérisable ou photoréticulable selon la revendication 1, dans laquelle le copolymère acrylique contient du méthacrylate de méthyle.

3. Une composition photopolymérisable ou photoréticulable selon les revendications 1 ou 2, dans laquelle le copolymère acrylique contient aussi de l'acide acrylique.

4. Une composition photopolymérisable ou photoréticulable selon lune quelconque des revendications 1 à 3, dans laquelle le copolymère acrylique contient aussi du méthacrylate de diméthylaminoéthyle.

5. Une composition photopolymérisable ou photoréticulable selon l'une quelconque des revendications 1 à 4, dans laquelle est présent au moins un composé monomère à insaturation éthylénique.

6. Une composition photopolymérisable ou photoréticulable selon la revendication 5, dans laquelle le copolymère acrylique contient du méthacrylate de méthyle.

7. Une composition photopolymérisable ou photoréticulable selon la revendication 6, dans laquelle le copolymère acrylique contient aussi de l'acide acrylique.

8. Une composition photopolymérisable ou photoréticulable selon les revendications 6 ou 7, dans laquelle le copolymère acrylique contient aussi du méthacrylate dimétylaminoéthyle.

**9.** Une composition selon l'une quelconque des revendications précédentes, appliquée sur un support.

**10.** Une composition selon la revendication 9, revêtue de poly(alcool vinylique).

**11.** Un procédé de production d'une composition photopolymérisable ou photoréticulable selon la revendication 1, consistant essentiellement en les étapes suivantes:
(a) à préparer un mélange de monomères contenant au moins un monomère acrylique ou méthacrylique et 15 à 25% en poids d'acrylate ou de méthacrylate de dicyclopentényle monomère;
(b) à ajouter le mélange de monomères au solvant dans un réacteur purgé à l'azote, et à le porter au reflux pendant plus d'une heure;
(c) à récupérer le copolymère acrylique du solvant et;
(d) à ajouter un photoamorceur ou un système photoamorceur.

**12.** Un procédé selon la revendication 11, dans lequel le copolymère acrylique est soluble dans un solvant, et la récupération a lieu par précipitation à l'eau.

**13.** Un procédé selon la revendication 11, dans lequel le copolymère acrylique est soluble dans les bases, et la récupération a lieu par dispersion à l'ammoniaque et précipitation par un acide.

**14.** Un procédé selon la revendication 11, dans lequel le copolymère acrylique est soluble dans les acides, et la récupération a lieu par dissolution dans un acide et précipitation par l'ammoniaque.

**Patentansprüche**

**1.** Photopolymerisierbare oder photo-vernetzbare Zusammensetzung, enthaltend ein acrylisches Copolymer, das nur aus Acryl-Monomeren und einem Photoinitiator oder Photoinitiatorsystem besteht, dadurch gekennzeichnet, daß das Acryl-Copolymer 15 bis 25 Gew.-% Dicyclopentenylacrylat oder -methacrylat enthält.

**2.** Photopolymerisierbare oder photo-vernetzbare Zusammensetzung nach Anspruch 1, wobei das Acryl-Copolymer Methylmethacrylat enthält.

**3.** Photopolymerisierbare oder photo-vernetzbare Zusammensetzung nach den Ansprüchen 1 oder 2, wobei das AcrylCopolymer auch Acrylsäure enthält.

**4.** Photopolymerisierbare oder photo-vernetzbare Zusammensetzung nach irgendeinem der Ansprüche 1 bis 3, wobei das Acryl-Copolymer auch Dimethylaminoethylmethacrylat enthält.

**5.** Photopolymerisierbare oder photo-vernetzbare Zusammensetzung nach irgendeinem der Ansprüche 1 bis 4, worin wenigstens eine ethylenisch ungesättigte Verbindung vorhanden ist.

**6.** Photopolymerisierbare oder photo-vernetzbare Zusammensetzung nach Anspruch 5, wobei das Acryl-Copolymer Methylmethacrylat enthält.

**7.** Photopolymerisierbare oder photo-vernetzbare Zusammensetzung nach Anspruch 6, wobei das Acryl-Copolymer auch Acrylsäure enthält.

**8.** Photopolymerisierbare oder photo-vernetzbare Zusammensetzung nach den Ansprüchen 6 oder 7, wobei das Acryl-Copolymer auch Dimethylaminoethylmethacrylat enthält.

**9.** Zusammensetzung nach irgendeinem der vorstehenden Ansprüche, die als Überzug auf einen Träger aufgebracht ist.

**10.** Zusammensetzung nach Anspruch 9, die mit Polyvinylalkohol überzogen ist.

**11.** Verfahren zur Herstellung einer photopolymerisierbaren oder photo-vernetzbaren Zusammensetzung nach Anspruch 1, im wesentlichen bestehend aus den Schritten:
a) Herstellung einer monomeren Mischung, die wenigstens ein Acryl- oder Methacryl-Monomer und 15 bis 25 Gew.-% Dicyclopentenylacrylat oder -methacrylat enthält,

b) Zugabe der monomeren Mischung zu Lösungsmittel in einem mit Stickstoff durchspülten Reaktionsgefäß und Erhitzen am Rückfluß für länger als 1 h,

c) Gewinnung des Acryl-Copolymers aus dem Lösungsmittel, und

d) Zugabe eines Photoinitiators oder Photoinitiator-Systems.

12. Verfahren nach Anspruch 11, wobei das Acryl-Copolymer lösungsmittellöslich ist und die Gewinnung durch Fällen mit Wasser geschieht.

13. Verfahren nach Anspruch 11, wobei das Acryl-Copolymer in Lauge löslich ist und die Gewinnung durch Dispergieren mit Ammoniak und Fällen mit Säure geschieht.

14. Verfahren nach Anspruch 11, wobei das Acryl-Copolymer in Säure löslich ist und die Gewinnung durch Lösen in Säure und Fällen mit Ammoniak geschieht.